# EUROPÄISCHE PATENTSCHRIFT

(11) **EP 0 850 490 B1**
(45) Veröffentlichungstag und Bekanntmachung des Hinweises auf die Patenterteilung: **07.11.2007**
(21) Anmeldenummer: 96928330.8
(22) Anmeldetag: 19.07.1996
(51) Int. Cl.: H01L 21/66, H01L 21/60

(54) **VERFAHREN UND VORRICHTUNG ZUM TESTEN EINES CHIPS**
PROCESS AND DEVICE FOR TESTING A CHIP
PROCEDE ET DISPOSITIF PERMETTANT DE VERIFIER UNE PUCE

(30) Priorität: 08.09.1995 DE 19533170; 12.01.1996 DE 19600994
(43) Veröffentlichungstag der Anmeldung: 01.07.1998
(73) Patentinhaber: Fraunhofer-Gesellschaft zur Förderung der angewandten Forschung e.V., 80686 München (DE); Zakel, Elke, 14612 Falkensee (DE); Pac Tech - Packaging Technologies GmbH, 14641 Nauen (DE)
(72) Erfinder: ZAKEL, Elke, 14612 Falkensee (DE); ANSORGE, Frank, D-12163 Berlin (DE); KASULKE, Paul, D-10551 Berlin (DE); OSTMANN, Andreas, D-10585 Berlin (DE); ASCHENBRENNER, Rolf, D-12055 Berlin (DE); DIETRICH, Lothar, D-13509 Berlin (DE)
(74) Vertreter: Böck, Bernhard
(86) Internationale Anmeldenummer: PCT/DE1996/001387
(87) Internationale Veröffentlichungsnummer: WO 1997/009740

(56) Entgegenhaltungen:
- EP-A- 0 485 760
- JP-A- 6 326 111
- US-A- 5 217 597
- US-A- 5 289 631
- US-A- 5 290 710
- US-A- 5 447 264
- MOTOROLA TECHNICAL DEVELOPMENTS, Bd. 25, 1.Juli 1995, Seiten 74-77, XP000524348 HUBACHER E: "KNOWN GOOD DIE TEST FOR C4 (OR OTHER) BUMPED DIE"
- PATENT ABSTRACTS OF JAPAN vol. 009, no. 004 (E-288), 10.Januar 1985 & JP,A,59 154035 (NIPPON DENSO KK), 3.September 1984,
- YAMAKAWA, K ET AL: "Maskless Bumping by Electroless Plating for High Pin count, thin, and low cost microcircuits" INTERNATIONAL JOURNAL FOR HYBRID MICROELECTRONICS, Bd. 13, Nr. 3, September 1990 (1990-09), Seiten 69-84, RESTON, VA, USA

## Beschreibung

Die vorliegende Erfindung betrifft ein Verfahren zum Testen eines mit einer Leiterbahnstruktur versehenen Substrats, insbesondere eines Chips nach dem Oberbegriff des Anspruchs 1, einen hierzu verwendbaren Lotdepotträger nach dem Oberbegriff des Anspruchs 11.

Die Herstellung eines montagefähigen IC's, wie er beispielsweise in elektronischen Geräten der EDV-Technik verwendet wird, gliedert sich, ausgehend von einem Wafer bis hin zu einem gehäusten, montagefähigen Chip, in eine Vielzahl von Fertigungsschritte.

Abgesehen von den Kosten, die durch die Herstellung des Wafers verursacht werden, werden die Kosten für die Herstellung eines montagefähigen, gehäusten Chips im wesentlichen durch die nachfolgenden Herstellungsschritte begründet. Diese sind im wesentlichen das Erzeugen von sogenannten Bumps auf den Anschlußflächen der durch Vereinzelung aus dem Wafer entstehenden Chips und das aufwendige Einhäusen der Chips. Zur Qualitätskontrolle der Chips erfolgt in der Regel eine elektrische Überprüfung der Leiterbahnstruktur des Chips nach dessen Einhäusung. Vielfach liegen jedoch die Ursachen für eine Fehlfunktion eines Chips in einem der Einhäusung des Chips vorhergehenden Fertigungsschritt begründet, so daß unnötigerweise fehlerhafte Chips, die bereits vor der Einhäusung Ausschuß darstellen, gehäust werden. Hierdurch werden die ohnehin mit dem Ausschuß verbundenen Kosten noch weiter erhöht.

Auch in der sogenannten "Flip-Chip-Technologie", bei der Chips mittels auf den Chip-Anschlußflächen aufgebrachten, erhöhten Kontaktmetallisierungen unmittelbar mit einem Substrat verbunden werden, erfolgt eine Qualitätskontrolle der Chips oder auch kompletter Wafer, die im Flip-Chip-Verfahren appliziert werden, erst nach der Verbindungsherstellung. Die Verarbeitung von Chips oder kompletten Wafern im Flip-Chip-Verfahren führt insgesamt zu komplexen Strukturen, die eine vollständige Testbarkeit einzelner Chips oder kompletter Wafer unter definierten Testbedingungen, wie sie zum Beispiel für einen Burn-In-Test vorgeschrieben sind, mit den bekannten Testverfahren nicht ohne Risiko für die gesamte Struktur zulassen.

Zwar ist es bekannt, einzelne Chips oder auch komplette Wafer vor Durchführung einer nachfolgenden Verbindungstechnik mit entsprechenden Testvorrichtungen zu überprüfen, jedoch ist eine derartige Qualitätskontrolle immer nur mit besonderem Aufwand durchführbar, der zur Durchführung der an sich schon komplexen Verbindungstechnik noch hinzukommt.

In der US 5,447,264 ist ein Lottdepotträger zur Ausbildung von Lotbumps auf Anschlußflächenmetallisierungen eines Chips beschrieben, der auch zur Durchführung eines Bauteiltests geeignet ist. Dazu ist ein elektrisch leitfähiges Substrat mit einer isolierenden, nicht mit Lot benetzbaren, Öffnungen aufweisenden Maske beschichtet. In die Löcher der Maske wird Lot galvanisch abgeschieden. Ein Chip wird mit seinen Anschlußflächen auf die Lotdepots aufgesetzt und die Lotdepots werden umgeschmolzen. Nach Ausbildung der Kontakte erfolgt ein Bauteiltest. Anschließend wird der Chip durch mechanische Kräfte vom Substrat abgeschert. Um eine Beschädigung des Chips beim Abscheren zu vermeiden, sind Löcher in der Maske deutlich kleiner als die Kontaktflächenmetallisierungen des Chips ausgebildet.

In der US 5,289,631 wird zur Ausführung eines elektrischen Bauteiltests ein mit Lotbumps versehener Chip auf eine mit einer Opferschicht versehene Leiterbahnanordnung aufgesetzt. Die Opferschicht befindet sich auf den Kontaktflächen der Leiterbahnanordnung, wobei die Kontaktflächen so ausgeführt sind, daß diese nicht vom Lot der Lotbumps benetzbar sind. Nach Durchführung des Bauteiltests wird die Anordnung erhitzt, die Opferschicht wird Teil der Lotbumps und der Chip wird vom Testsubstrat abgehoben.

In "Motorola Technical Developments", Bd. 25 (1. Juli 1995), Schaumburg, IL, USA, Seiten 74-77, ist ein Verfahren zur Durchführung eines elektrischen Bauteiltests eines mit Lotbumps versehenen Chips beschrieben. Um eine Deformierung der Lotbumps zu verhindern, werden die Lotbumps mit einer Schutzschicht aus niedrig schmelzendem Lot überzogen und auf einem Testsubstrat aufgebracht, auf dem der Bauteiltest erfolgt. Nach Durchführung des Tests wird der Chip vom Testsubstrat abgehoben, und die Lotbumps des Chips werden vom verbliebenen, niedrig schmelzenden Lot gereinigt.

Der vorliegenden Erfindung liegt daher die Aufgabe zugrunde, ein Verfahren bzw. eine Vorrichtung vorzuschlagen, mit dem bzw. der es bereits vor dem Herstellungsstadium des Einhäusens eines Chips bzw. vor Durchführung der Verbindungstechnik möglich ist, auf kostengünstige Art und Weise eine Qualitätsprüfung durchzuführen.

Diese Aufgabe wird durch ein Verfahren mit den Merkmalen des Anspruchs 1 bzw. eine Vorrichtung mit den Merkmalen des Anspruchs 11 gelöst.

Bei dem erfindungsgemäßen Verfahren erfolgt mittels eines Lotdepotträgers, der mit einer Leiterbahnstruktur mit Anschlußflächen zur Anordnung von Lotdepots und deren Übertragung auf entsprechend angeordnete Anschlußflächen eines Substrats versehen ist, während der Übertragung der Lotdepots im Schmelzflüssigen Zustand eine elektrische Überprüfung der Leiterbahnstruktur des Substrats.

Somit kann das Substrat, das etwa als eine Leiterplatte mit einer mehr oder weniger komplexen Leiterbahnstruktur oder als ein Chip ausgebildet sein kann, durch eine individuelle Kontaktierung seiner Anschlußflächen über den Lotdepotträger auf seine Funktionsfähigkeit hin überprüft werden.

Hierdurch wird deutlich, daß die elektrische Überprüfung der Leiterbahnstruktur des Substrats während dessen Herstellungsverfahrens mit keinem zusätzlichen Verfahrensschritt verbunden ist. Vielmehr wird durch das erfindungsgemäße Verfahren quasi eine inhärente Qualitätsprüfung während eines ohnehin notwendigen Herstellungsschritts ermöglicht. Zudem findet die elektrische Überprüfung der Leiterbahnstruktur des Substrats vor dessen Fertigstellung durch eine abschließende Einhäusung bzw. vor Herstellung einer endgültigen Kontaktierung im Flip-Chip-Verfahren statt, so daß die Weiterverarbeitung von Substraten mit fehlerhaften Leiterbahnstrukturen vermieden wird.

Wenn vor Anordnung der Lotdepots auf der strukturierten, elektrisch leitfähigen Beschichtung eine Übertragungsmaske mit die Anschlußflächen freigebenden Maskenöffnungen auf die Beschichtung aufgebracht wird, lassen sich auch andere Verfahren als eine Applikation von stückigem Lotmaterial zur Ausbildung der Lotdepots auf dem Lotdepotträger verwenden. Neben einer chemischen Abscheidung von Lotmaterial zur Ausbildung der Lotdepots in den Maskenöffnungen eignet sich in besonderer Weise, wegen der ohnehin zur Durchführung des Tests notwendigen elektrisch leitfähigen Beschichtung eine galvanische Abscheidung von Lotmaterial zur Ausbildung der Lotdepots auf den Anschlußflächen. Dabei wird die Form der Lotdepots im wesentlichen durch die Ausgestaltung der Maskenöffnungen bestimmt. Darüber hinaus ist es auch möglich, das Lotmaterial in Form von Lotpaste aufzubringen.

Eine besonders sichere Kontaktierung zwischen dem als Prüfkontaktanordnung dienenden Lotdepotträger und den Anschlußflächen des Substrats ergibt sich, wenn nach Herstellung eines Berührungskontakts zwischen den Lotdepots des Lotdepotträgers und den Anschlußflächen des Substrats ein zumindest partielles Aufschmelzen der Lotdepots zur Herstellung einer Lotverbindung zwischen dem Lotdepotträger und dem Substrat erfolgt. Diese Lotverbindung kann durch eine Benetzung der Anschlußflächen des Substrats, also quasi durch einen anschmiegenden Formschluß zwischen den Lotdepots und den Anschlußflächen oder bedingt durch eine nachfolgende Erstarrung der Lotdepots als stoffschlüssige Verbindung zwischen den Lotdepots und den Anschlußflächen bewirkt werden. In jedem Fall sichert die Lotverbindung während der elektrischen Überprüfung der Leiterbahnstruktur des Substrats einen guten Kontakt mit geringstmöglichem Kontaktwiderstand.

Wenn bei einem partiellen Aufschmelzen der Lotdepots zunächst ein Aufschmelzen eines benachbart der Anschlußfläche des Substrats angeordneten Kontaktteils und anschließend ein Aufschmelzen eines an den Kontaktteil angrenzenden Basisteils erfolgt, besteht die Möglichkeit, das zur Übertragung der Lotdepots notwendige Aufschmelzen in zwei Phasen, nämlich einer Kontaktschmelzung und einer Übertragungsschmelzung, die durch unterschiedliche Temperaturen gekennzeichnet sind, durchzuführen, um somit unabhängig von der Lotmaterialzusammensetzung des Basisteils eine hinsichtlich ihres Schmelzpunkts auf die zur Durchführung des Tests vorgegebene Testtemperatur ausgelegte Lotmaterialzusammensetzung des Kontaktteils wählen zu können.

Der vorstehenden Vorgehensweise liegt der Gedanke zugrunde, die zur Durchführung des Tests besonders vorteilhafte, durch einen möglichst geringen Übergangswiderstand gekennzeichnete formschlüssige Lotverbindung unabhängig von der die elektrischen Eigenschaften des Lotdepots im wesentlichen bestimmenden Materialzusammensetzung des Basisteils festlegen zu können.

Insbesondere in energetischer Hinsicht ist es besonders vorteilhaft, wenn sich während der elektrischen Überprüfung der Leiterbahnstruktur des Substrats der Kontaktteil im schmelzflüssigen Zustand und der Basisteil im festen Zustand befinden. Die Überprüfung kann jedoch auch im festen Zustand des Kontaktteils und des Basisteils erfolgen.

Wenn bei Übertragung des insgesamt schmelzflüssigen Lotdepots eine Mitübertragung einer auf den Anschlußflächen der elektrisch leitfähigen Beschichtung des Lotdepotträgers angeordneten Anschlußflächenmetallisierung erfolgt, wird sicher ausgeschlossen, daß Lotmaterial des Lotdepots bei der Übertragung auf den Anschlußflächen des Lotdepotträgers zurückbleiben kann und nur eine unvollständige Übertragung des Lotdepots erfolgt.

Als vorteilhaft erweist es sich auch, wenn die zum Aufschmelzen der Lotdepots benötigte Energie, zumindest anteilig über die elektrisch leitfähige Beschichtung des Lotdepotträgers in die Lotdepots eingebracht wird. Hierdurch ist es möglich, auch während des Tests der Leiterbahnstruktur eine Wärmeverteilung einzustellen, wie sie zumindest annähernd dem tatsächlichen Betriebsfall entspricht, bei dem im Bereich der Anschlußflächen Temperaturspitzen auftreten.

Weiterhin erweist es sich als vorteilhaft, wenn während des Bestehens der Verbindung zwischen dem Lotdepotträger und dem Substrat über die elektrisch leitfähige Beschichtung des Lotdepotträgers eine Temperierung des Substrats erfolgt. Hierdurch kann die ohnehin mit dem Aufschmelzen der Lotdepots verbundene Wärmebeaufschlagung des Substrats gleichzeitig zur Einstellung von Testbedingungen genutzt werden, wie sie beispielsweise bei sogenannten Burn-In-Tests, einer Kombination von Hochtemperaturumgebung und elektrischem Betrieb, vorliegen.

Wenn zur Übertragung der Lotdepots vom Lotdepotträger auf die Anschlußflächen des Substrats das Substrat mit seinen Anschlußflächen in einer Überdeckungslage mit den Lotdepots von oben auf den Lotdepotträger abgesenkt und nachfolgend zusammen mit den an den Anschlußflächen des Substrats haftenden Lotdepots nach oben abgehoben wird, läßt sich die Übertragung der Lotdepots mit gleichzeitiger Testung der Leiterbahnstruktur des Substrats während einer üblichen Flip-Chip-Handhabung des Substrats durchführen. Ein besonderer Vorteil dieser Handhabung des Substrats liegt darin, daß nachfolgend eine Flip-Chip-Kontaktierung des Substrats zur Anordnung auf einem weiteren Substrat erfolgen kann, ohne daß die Handhabungseinrichtung gewechselt werden müßte. Somit ist beispielsweise eine kontinuierliche Weiterverarbeitung der gemäß dem erfindungsgemäßen Verfahren überprüften Chips zum Aufbau eines Multi-Chip-Moduls leicht möglich. Darüber hinaus können das Substrat und der Lotdepotträger bei der Übertragung auch umgekehrt angeordnet sein.

Wenn das zumindest partielle Aufschmelzen der Lotdepots und/oder deren Übertragung vom Lotdepotträger auf das Substrat in einem gasförmigen oder flüssigen reduzierenden oder inerten Medium erfolgt, läßt sich sicherstellen, daß die Lotdepots von schädlichen Umgebungseinflüssen während des Aufschmelzens und Übertragens der Lotdepots weitestgehend abgeschirmt werden. Das dabei verwendete Medium kann aus einem Schutzgas oder auch einem flüssigen Medium bestehen. Als flüssiges Medium eignen sich besonders Polyalkohole, wie Glycerin, Tetraethylenglykol und Polyethylenglykol, und Stearine.

Aus der US 5,217,597 ist eine Vorrichtung zur Übertragung von Lotdepots auf Anschlußflächen eines mit einer Leiterbahnstruktur versehenen Substrats bekannt, wobei ein Lotdepotträger eine Trägerschicht mit einer elektrisch leitfähigen Beschichtung mit Anschlußflächen zur Anordnung von Lotdepots und deren Übertragung auf entsprechend angeordnete Anschlußflächen des Substrats aufweist. Bei der erfindungsgemäßen Vorrichtung weist die elektrisch leitfähige Beschichtung des Lotdepotträgers eine Leiterbahnstruktur auf.

Somit ermöglicht der zur Übertragung von Lotdepots auf Anschlußflächen eines Substrats verwendete Lotdepotträger erfindungsgemäß eine gleichzeitige elektrische Überprüfung der Leiterbahnstruktur durch eine individuelle Kontaktierung der Anschlüsse des Substrats.

Wenn die Anschlußflächen zur Anordnung der Lotdepots durch Maskenöffnungen einer auf der Beschichtung angeordneten Übertragungsmaske definiert sind, lassen sich nicht nur Verfahren zur Applikation der Lotdepots in im wesentlichen fester Form, sondern auch Verfahren zur Applikation der Lotdepots mittels chemischer oder galvanischer Abscheidung einsetzen, bei denen also das Lotmaterial nicht in fester, sondern in fluider Form vorliegt.

Wenn die Anschlußflächen des Lotdepotträgers eine kleinere Benetzungsfläche als die Anschlußflächen des Substrats aufweisen, ist ein Aufschmelzen und eine nachfolgende Übergabe der aufgeschmolzenen Lotdepots aufgrund der größeren Haftkräfte zwischen den aufgeschmolzenen Lotdepots und den Anschlußflächen des Substrats durch einfaches Abheben des Substrats vom Lotdepotträger möglich, ohne daß die Anschlußflächen des Lotdepotträgers eine benetzungsunfähige Anschlußflächenmetallisierung aufweisen müßten. Hierdurch wird eine Ausbildung der elektrisch leitfähigen Beschichtung des Lotdepotträgers als einfache, strukturierte Metallisierung möglich.

Wenn die Anschlußflächen des Lotdepotträgers mit einer benetzungshemmenden oder benetzungsunfähigen Anschlußflächenmetallisierung versehen sind, ist es möglich, die Anschlußflächen des Lotdepotträgers in ihrer Flächengröße übereinstimmend mit den Anschlußflächen des Substrats auszubilden.

Zur Ausbildung einer benetzungsunfähigen oder nichtbenetzbaren Anschlußflächenmetallisierung hat es sich als vorteilhaft herausgestellt, wenn diese eine Wolfram/Titan-Legierung oder eine Legierung aus Wolfram und einem Titanoxid aufweist.

Abgesehen von den vorgenannten Zweistoff-Legierungen können auch Mehrstoff-Legierungen zur Ausbildung einer benetzungsunfähigen oder nichtbenetzbaren Anschlußflächenmetallisierung verwendet werden. Je nach Lotmaterialauswahl für die Lotdepots eignen sich auch besonders gut Einstoff-Metallisierungen, wie Wolfram, Titan, Chrom, Tantal oder Molybdän oder auch deren Oxide.

Grundsätzlich weist eine nichtbenetzbare Anschlußflächenmetallisierung den Vorteil auf, daß eine Haftung zwischen der Anschlußflächenmetallisierung und dem Lotdepot nur im festen, erstarrten Zustand des Lotdepotmaterials möglich ist. Während des Aufschmelzens des Lotdepots findet eine Entnetzung und Ablösung des Lotdepotmaterials von der nichtbenetzbar ausgebildeten Anschlußflächenmetallisierung statt, so daß keine weitere Haftung mehr erfolgt und eine einfache, im wesentlichen rückstandsfreie Übertragung des Lotmaterials vom Lotdepotträger auf das Substrat erfolgen kann, ohne daß hierzu besondere Trennkräfte notwendig wären.

Eine weitere Möglichkeit, eine im wesentlichen rückstandsfreie Übertragung des Lotmaterials vom Lotdepotträger auf das Substrat zu ermöglichen, besteht darin, die Anschlußflächen des Lotdepotträgers mit einer benetzbaren, im Lotmaterial des Lotdepots löslichen Anschlußflächenmetallisierung zu versehen. Bei einer derartigen Auswahl des Materials für die Anschlußflächenmetallisierung erfolgt nämlich eine Mitübertragung der Anschlußflächenmetallisierung zusammen mit dem Lotmaterial des Lotdepots. Als besonders vorteilhaft erweist es sich in diesem Zusammenhang, wenn bei einer benetzbar ausgebildeten Anschlußflächenmetallisierung die darunterliegend angeordnete, elektrisch leitfähige Beschichtung nichtbenetzbar ausgebildet ist, um zu erreichen, daß bei der Mitübertragung der Anschlußflächenmetallisierung die strukturierte, elektrisch leitfähige Beschichtung des Lotdepotträgers im wesentlichen unversehrt erhalten bleibt, so daß die erneute Verwendung des Lotdepotträgers sichergestellt ist.

Als vorteilhaft für die Ausbildung einer benetzbaren Anschlußflächenmetallisierung hat es sich herausgestellt, wenn diese eine Gold- oder eine Palladiumlegierung aufweist.

Die Ausbildung eines Lotdepots mit einem Kontaktteil und einem Basisteil, wobei die Schmelztemperatur des Kontaktteils kleiner ist als die Schmelztemperatur des Basisteils, ermöglicht nämlich eine besonders widerstandsarme Kontaktierung zu Prüfzwecken, wie beispielsweise einen "Burn-In-Test", ohne daß hierzu ein Aufschmelzen des gesamten Lotdepots mit der entsprechend hohen Temperaturbelastung des Substrats erforderlich ist. Der Lotdepotträger übernimmt dabei die Funktion einer Prüfplatine oder eines Prüfsubstrats, und bei den Lotdepots kann es sich um die bereits auf den Anschlußflächen eines Substrats applizierten, mit dem Fachwort "Bumps" bezeichneten, erhöhten Kontaktmetallisierungen handeln.

Als besonders vorteilhaft erweist es sich, wenn die Schmelztemperatur des Kontaktteils im wesentlichen gleich der für eine elektrische Überprüfung der Leiterbahnstruktur des Substrats vorgegebenen Prüftemperatur ist, da somit im wesentlichen nur soviel Energie zum Aufschmelzen des Kontaktteils aufgebracht werden muß, wie zur Erreichung der Prüftemperatur notwendig ist.

Wenn der Basisteil und der Kontaktteil dieselben Legierungskomponenten aufweisen und der Kontaktteil abweichend vom Basisteil eine eutektische Zusammensetzung aufweist, sind die vorstehend erläuterten Vorteile des Lotdepots aus einem Basisteil und einem Kontaktteil mit insgesamt nur zwei Legierungskomponenten bei einer möglichst niedrigen Schmelztemperatur des Kontaktteils möglich.

Nachfolgend wird das erfindungsgemäße Verfahren bzw. die erfindungsgemäße Vorrichtung anhand in den Zeichnungen dargestellter Ausführungsbeispiele näher erläutert. Es zeigen:
**Fig. 1** eine Schnittdarstellung eines Lotdepotträgers;
**Fig. 2** eine perspektivische Darstellung des in **Fig. 1** gezeigten Lotdepotträgers;
**Fig. 3** eine strukturierte Metallisierung des Lotdepotträgers;
**Fig. 4** eine Schnittdarstellung des Lotdepotträgers entsprechend der Darstellung in **Fig. 1** mit auf Anschlußflächen des Lotdepotträgers angeordneten Lotdepots;
**Fig. 5** einen in Überdeckungslage oberhalb des in **Fig. 4** dargestellten Lotdepotträgers angeordneten Chip zur nachfolgenden Übertragung der Lotdepots auf die Anschlußflächen des Chips im Flip-Chip-Verfahren;
**Fig. 6** den in **Fig. 5** dargestellten, mit seinen Anschlußflächen auf die aufgeschmolzenen Lotdepots abgesenkten Chip zur Ausbildung einer Übertragungs-/Testkonfiguration;
**Fig. 7** den in **Fig. 6** dargestellten, zusammen mit den Lotdepots vom Lotdepotträger abgenommenen Chip;
**Fig. 8** eine Schnittdarstellung eines weiteren Lotdepotträgers mit auf Anschlußflächen des Lotdepotträgers angeordneten Lotdepots mit einem Basisteil und einem Kontaktteil;
**Fig. 9** einen in Überdeckungslage oberhalb des in **Fig. 8** dargestellten Lotdepotträgers angeordneten Chip zur nachfolgenden Übertragung der Lotdepots auf die Anschlußflächen des Chips im Flip-Chip-Verfahren;
**Fig. 10** den in **Fig. 9** dargestellten, mit seinen Anschlußflächen auf den aufgeschmolzenen Kontaktteil der Lotdepots abgesenkten Chip zur Ausbildung einer Testkonfiguration;
**Fig. 11** die in **Fig. 10** dargestellte Chip/Lotdepotträger-Konfiguration, wobei neben dem Kontaktteil der Lotdepots auch der Basisteil der Lotdepots zur Ausbildung einer Übertragungskonfiguration aufgeschmolzen ist;
**Fig. 12** den in **Fig. 11** dargestellten, zusammen mit den Lotdepots und den Anschlußflächenmetallisierungen vom Lotdepotträger abgenommenen Chip.

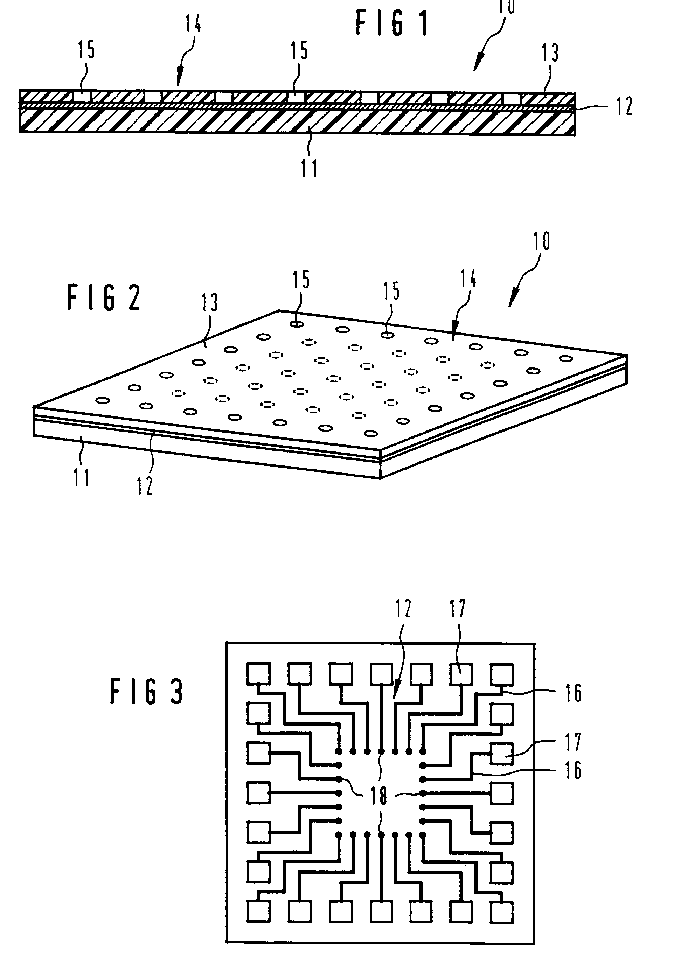

**Fig. 1** zeigt einen Lotdepotträger 10 mit einer Trägerschicht 11 und einer auf der Trägerschicht 11 aufgebrachten elektrisch leitfähigen Beschichtung, die hier als eine strukturierte Metallisierung in Form einer Leiterbahnstruktur 12 ausgebildet ist. Auf der Leiterbahnstruktur 12 befindet sich eine fotosensitive Polymerschicht 13, die über ein an sich bekanntes, fotolithographisches Verfahren in der dargestellten Art und Weise zur Ausbildung einer Übertragungsmaske 14 strukturiert ist und Maskenöffnungen 15 aufweist.

**Fig. 2** zeigt die Übertragungsmaske 14 mit den Maskenöffnungen 15 in einer Draufsicht. Neben den mit durchgezogenen Linien parallel zum Umfang des Lotdepotträgers 10 angeordneten Maskenöffnungen 15, die in ihrer Anordnung einer konventionellen Input-/output-Anschlußflächenanordnung eines Chips entsprechen, sind bei dem in **Fig. 2** dargestellten Ausführungsbeispiel gleichmäßig über den Innenbereich der Polymerschicht 13 verteilt weitere mit gestricheltem Linienverlauf dargestellte Maskenöffnungen 15 eingezeichnet, die verdeutlichen sollen, daß der Lotdepotträger 10 ebensogut mit einer Übertragungsmaske 14 versehen werden kann, die hinsichtlich ihrer Anordnung von Maskenöffnungen 15 einem sogenannten "Ball-Grid-Array" entspricht.

Für die Input-/Output-Anschlußflächenanordnung der Maskenöffnungen 15 ist in **Fig. 3** die Leiterbahnstruktur 12 dargestellt. Wie aus einem Vergleich der **Fig. 2** und **3** deutlich wird, befinden sich dabei an den Enden einzelner Leiterbahnen 16 der Leiterbahnstruktur 12 angeordnete Anschlußflächen 17 unterhalb der zugeordneten Maskenöffnungen 15, so daß über die Übertragungsmaske 14 eine äußere Kontaktierung der Anschlußflächen 17 möglich ist.

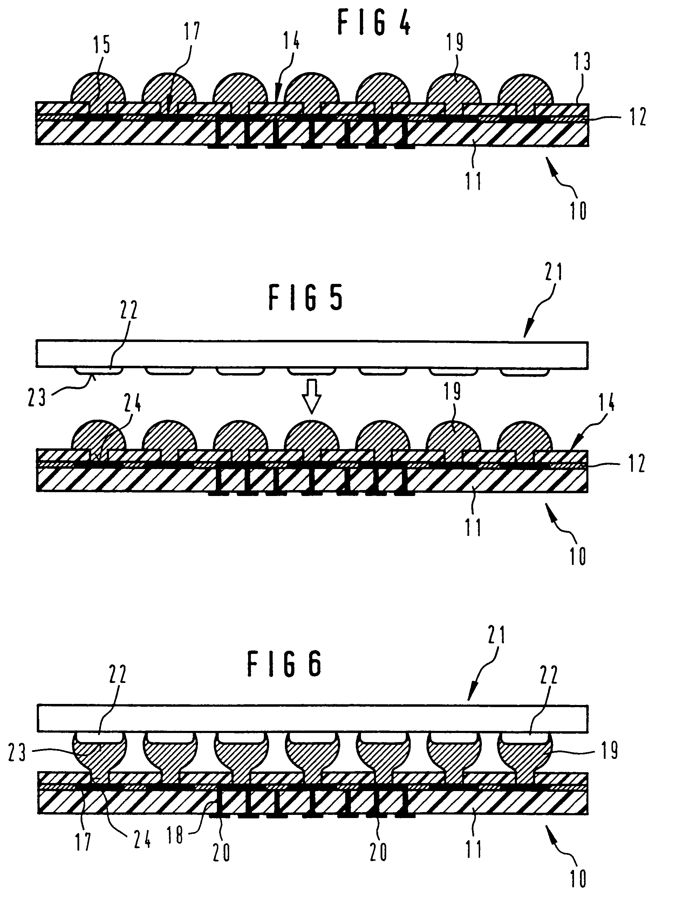

**Fig. 4** zeigt den Lotdepotträger 10 mit auf den Maskenöffnungen 15 angeordneten Lotdepots 19. Die Anordnung der Lotdepots 19 auf den Maskenöffnungen 15 kann über eine galvanische Lotabscheidung erfolgen, bei der die Leiterbahnen 16 der Leiterbahnstruktur 12 miteinander kurzgeschlossen werden und somit die Leiterbahnstruktur 12 insgesamt als Elektrode dient, auf deren durch die Übertragungsmaske 14 freigegebenen Anschlußflächen 17 die Abscheidung von Lotmaterial in Form der Lotdepots 19 erfolgt. Dabei wird eine Ablagerung von Lotmaterial auf den übrigen Bereichen der Übertragungsmaske 14 durch deren Ausbildung als benetzungsunfähige, nicht leitende Polymerschicht 13, etwa aus Polyimid oder BCB, verhindert. Eine benetzungsunfähige, nicht leitende Oberfläche der Übertragungsmaske 14 läßt sich auch durch Verwendung einer Oxid- oder Nitridschicht erzielen.

Bei entsprechender Ausbildung der Übertragungsmaske, insbesondere bei größerer Dimensionierung der Maskenöffnungen 15 ist es auch möglich, statt einer, wie vorstehend geschildert, galvanischen Abscheidung von Lotmaterial zur Ausbildung von Lotdepots 19, die Lotdepots in fester Form in den Maskenöffnungen 15 zu plazieren.

Unabhängig von der Art und Weise der Anordnung bzw. Ausbildung der Lotdepots 19 auf den Anschlußflächen 17 der Leiterbahnstruktur 12 wird, wie in **Fig. 5** dargestellt, nachfolgend ein hier als Chip 21 ausgebildetes Substrat mit seinen Anschlußflächen bildenden, erhöhten Kontaktmetallisierungen, die nachfolgend fachsprachlich als Bumps 22 bezeichnet werden, in Überdeckung mit den Lotdepots 19 des Lotdepotträgers 10 gebracht und zur Ausbildung eines Berührungskontakts zwischen den Bumps 22 und den Lotdepots 19 auf diese abgesenkt.

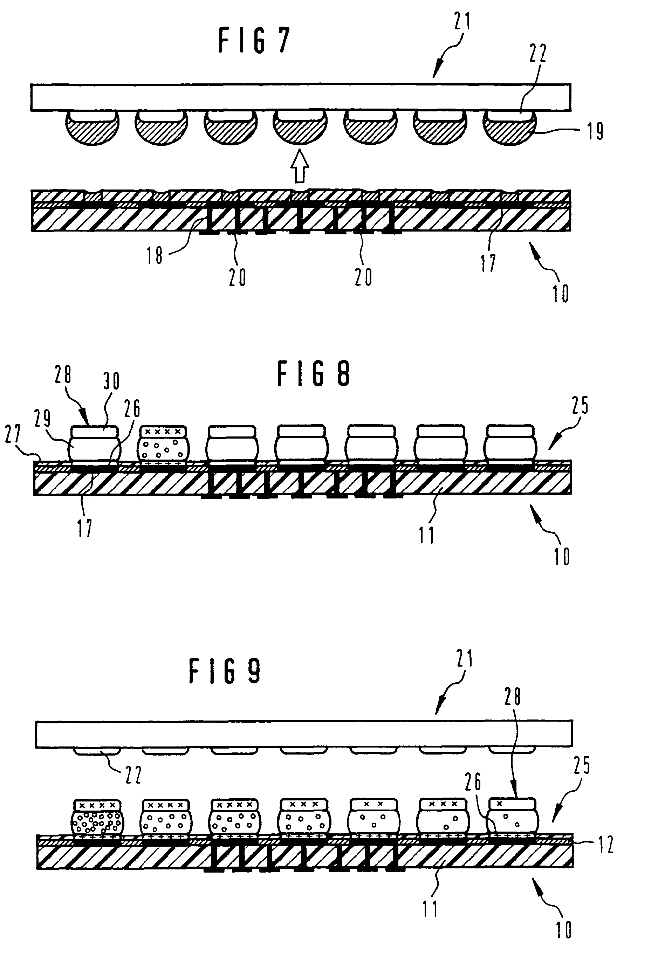

Danach erfolgt, wie in **Fig. 6** dargestellt, ein Aufschmelzen der Lotdepots 19, so daß sich die in **Fig. 6** dargestellte Benetzung der Bumps 22 durch die aufgeschmolzenen Lotdepots 19 ergibt. Um sicherzustellen, daß sich infolge des Aufschmelzens der Lotdepots 19 und der damit verbundenen Erwärmung des Lotdepotträgers 10 und des Chips 21 keine Abweichungen von der in **Fig. 6** dargestellten Überdeckungslage zwischen den Bumps 22 und den Lotdepots 19 ergeben, sollten sowohl die Trägerschicht 11 des Lotdepotträgers 10 als auch das Material des Chips 21 einen im wesentlichen übereinstimmenden Ausdehnungskoeffizienten aufweisen. Geringfügige Abweichungen zwischen den Ausdehnungskoeffizienten können durch mögliche Verlagerungen der aufgeschmolzenen Lotdepots 19 ausgeglichen werden. Bei dem hier dargestellten Ausführungsbeispiel wird für die Trägerschicht 11 des Lotdepotträgers 10 übereinstimmend mit dem Material des Chips 21 Silizium gewählt.

Aufgrund einer gegenüber einer Benetzungsfläche 23 der Bumps 22 um ein mehrfaches kleineren Benetzungsfläche 24 der Maskenöffnungen 15 bildet sich die in **Fig. 6** dargestellte Form der aufgeschmolzenen Lotdepots 19 aus, die es, wie in **Fig. 7** dargestellt, ermöglicht, den Chip 21 bei fortwährender Benetzung der Bumps 22 durch die Lotdepots 19 zusammen mit diesen vom Lotdepotträger 10 abzuheben. Dabei verbleiben, wie in **Fig. 7** schematisch dargestellt, lediglich geringe Anteile von Lotmaterial auf der Übertragungsmaske 14, die bei wiederholter Verwendung der Übertragungsmaske 14 zur Übertragung von Lotdepots 19 auf einem weiteren Chip 21 leicht, etwa auf naßchemischem Wege, entfernt werden können.

Aufgrund der in **Fig. 3** dargestellten, strukturierten Metallisierung zur Ausbildung der Leiterbahnstruktur 12 mit elektrisch voneinander unabhängigen Leiterbahnen 16 ist es möglich, während des in **Fig. 6** dargestellten Kontakts zwischen dem Chip 21 und dem Lotdepotträger 10 zur nachfolgenden Übertragung der Lotdepots 19 auf die Bumps 22 des Chips 21 über die Lotdepots 19 eine elektrische Überprüfung der hier nicht näher dargestellten Leiterbahnstruktur des Chips 21 durchzuführen. Dazu kann die Leiterbahnstruktur des Chips 21 durch gezielte Beaufschlagung von auf der Rückseite des Lotdepotträgers 10 angeordneten Prüfkontakten 20, die über Durchkontaktierungen 18 (**Fig. 3**) mit den Leiterbahnen 16 verbunden sind, mit einer Prüfspannung getestet werden.

Zur Herstellung einer festen Verbindung zwischen den Anschlußflächen 17 des Lotdepotträgers 10 und den Bumps 22 erfolgt eine Abkühlung der aufgeschmolzenen Lotdepots 19. Im Falle der Verwendung einer eutektischen Blei/Zinn-Legierung für das Lotmaterial der Lotdepots 19 und mit Gold beschichteter, naßchemisch erzeugter Bumps 22 aus Nickel des Chips 21 muß hierzu die Temperatur der Lotdepots nach dem Aufschmelzen auf unter 180° C abgesenkt werden.

Nach Durchführung der elektrischen Überprüfung der Leiterbahnstruktur des Chips 21 erfolgt dann wieder eine Erwärmung der Lotdepots 19 auf eine Temperatur oberhalb 180° C, um diese aufzuschmelzen und dann, wie vorstehend beschrieben, den Chip 21 zusammen mit den an den Bumps 22 haftenden Lotdepots 19 vom Lotdepotträger 10 abzuheben.

Grundsätzlich ist die vorstehend beschriebene elektrische Überprüfung der Leiterbahnstruktur des Chips 21 mittels des Lotdepotträgers 10 auch während des schmelzflüssigen Zustands der Lotdepots 19 möglich; wesentlich ist, daß während der elektrischen Überprüfung ein sicherer Kontakt zwischen den Bumps 22 des Chips 21 und den Anschlußflächen 17 des Lotdepotträgers 10 besteht. Dies ist auch dann der Fall, wenn eine entsprechende Benetzung der Anschlußflächen 17 bzw. der Bumps 22 gegeben ist. Um jedoch beispielsweise einen hinsichtlich seiner Randbedingungen definierten Burn-In-Test durchführen zu können, etwa bei einer Temperatur von 150° C über eine Zeit von 125 Stunden, müssen die Lotdepots 19 bei dem hier beispielhaft verwendeten Lotmaterial aus einer Blei/Zinn-Legierung in den festen Zustand überführt werden.

Bei dem anhand der vorstehend erläuterten Figuren beschriebenen Ausführungsbeispiel wird die Übertragung der Lotdepots 19 vom Lotdepotträger 10 auf den Chip 21 im wesentlichen durch die unterschiedlich groß gestalteten Benetzungsflächen 23, 24 der Anschlußflächen 17 des Lotdepotträgers 10 bzw. der Bumps 22 des Chips 21 ermöglicht. Die sich daraus ergebenden unterschiedlich großen Haftkräfte zwischen den aufgeschmolzenen Lotdepots 19 und den Anschlußflächen 17 bzw. den Bumps 22 lassen sich jedoch auch auf anderem Wege erreichen. So ist es beispielsweise möglich, unabhängig von Größenunterschieden zwischen den Benetzungsflächen 23 und 24 die notwendigen unterschiedlich großen Haftkräfte dadurch zu erzeugen, daß auf die Anschlußflächen 17 des Lotdepotträgers eine benetzungshemmende oder benetzungsunfähige Sperrschicht aufgebracht wird.

**Fig. 8** zeigt in Abwandlung von dem in **Fig. 4** dargestellten Lotdepotträger 10 einen Lotdepotträger 25, der bei dem hier dargestellten Ausführungsbeispiel über keine Übertragungsmaske verfügt. Ansonsten weist der Lotdepotträger 25 dieselben, mit identischen Bezugszeichen versehenen Elemente auf wie der Lotdepotträger 10.

Die Anschlußflächen 17 des Lotdepotträgers 25 sind mit einer Anschlußflächenmetallisierung 26 versehen, wohingegen die übrige Oberfläche der Leiterbahnstruktur 12 mit einer Passivierung 27 abgedeckt ist. Auf die Anschlußflächenmetallisierung 26 aufgebracht befinden sich Lotdepots 28, die jeweils aus einem an die Anschlußflächenmetallisierung 26 unmittelbar angrenzenden Basisteil 29 und einem auf den Basisteil 29 aufgebrachten Kontaktteil 30 bestehen.

Bei dem hier dargestellten Ausführungsbeispiel sind die Lotdepots 28 stückig durch Preßschweißung auf die im Vergleich zu den Lotdepots 28, insbesondere zu dem Basisteil 29 der Lotdepots 28 dünnen Anschlußflächenmetallisierungen 26 aufgebracht. Dabei werden die Lotdepots 28 in zwei Phasen aufgebaut, wobei zunächst eine Verbindung des Basisteils 29 mit der Anschlußflächenmetallisierung 26 und anschließend ein "Aufstocken" des Basisteils 29 um den Kontaktteil 30 zur Ausbildung des vollständigen Lotdepots 28 erfolgt. Derartige mehrlagig aufgebaute Lotdepots können auch abweichend von der vorstehend beschriebenen Art und Weise hergestellt werden, beispielsweise durch schichtweises Abscheiden von Lotmaterialien. Bei dem Aufbau der Lotdepots aus fluiden Materialien erweist sich dann wieder die Verwendung einer ihrer Art nach in **Fig. 4** dargestellten Übertragungsmaske als vorteilhaft.

Bei den in **Fig. 8** dargestellten Lotdepots 28 besteht sowohl der Basisteil 29 als auch der Kontaktteil 30 aus einer Blei/Zinn-Legierung, wobei für den Basisteil 29 eine hoch bleihaltige Legierung, beispielsweise PbSn 90/10 oder PbSn 95/5 und für den Kontaktteil 30 eine eutektische Blei/Zinn-Legierung gewählt ist.

Entsprechend der Darstellung gemäß **Fig. 5** wird, wie **Fig. 9** zeigt, zur Herstellung einer Test- bzw. Übertragungskonfiguration der Chip 21 mit seinen Bumps 22 in Überdeckung mit den Lotdepots 28 des Lotdepotträgers 25 gebracht und zur Ausbildung eines Berührungskontakts zwischen den Bumps 22 und den Lotdepots 28 auf diese abgesenkt.

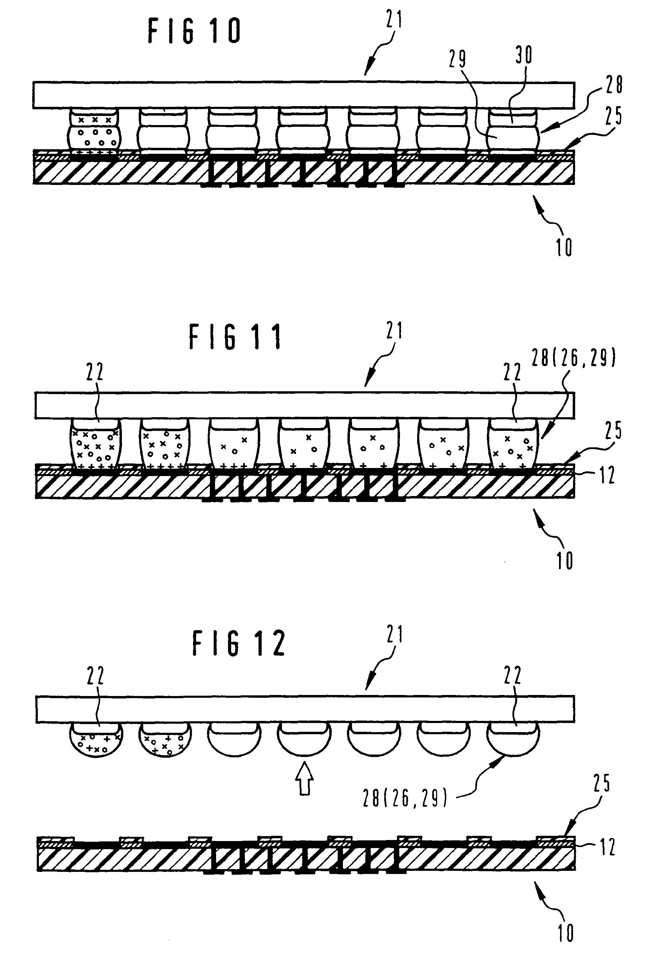

Danach erfolgt, wie in **Fig. 10** dargestellt, ein Aufschmelzen des Kontaktteils 30 der Lotdepots 28, wodurch sich eine entsprechende Benetzung der benetzbaren Bumps 22 des Chips 21, verbunden mit der Ausbildung eines entsprechend guten elektrischen Kontakts ergibt.

In der in **Fig. 10** dargestellten reinen Testkonfiguration befindet sich der Basisteil 29 der Lotdepots 28 nach wie vor im erstarrten Zustand. Durch den aufgeschmolzenen Kontaktteil 30 wird ein formschlüssiger Brückenkontakt zwischen dem Lotdepotträger 25 und dem Chip 21 geschaffen, so daß die vorstehend im Zusammenhang mit dem Lotdepotträger 10 bereits ausführlich beschriebene elektrische Überprüfung der Leiterbahnstruktur des Chips 21 erfolgen kann.

Die Aufschmelztemperatur des Kontaktteils 30 beträgt bei Verwendung einer eutektischen Blei/Zinn-Legierung für den Kontaktteil 30 etwa 180° C und liegt somit im Bereich einer bei einem Burn-In-Test üblichen Prüftemperatur. Demgegenüber beträgt die Schmelztemperatur des hoch bleihaltigen Basisteils über 200° C. Bei ganzheitlicher Ausbildung des Lotdepots aus einer hoch bleihaltigen Legierung wäre somit eine wesentlich höhere Temperatur erforderlich, um ein Aufschmelzen des Lotdepots zu bewirken und den damit beabsichtigten, formschlüssigen Kontakt zwischen den Lotdepots und den Bumps des Chips für eine elektrische Überprüfung herzustellen.

Erst wenn durch Aufschmelzen lediglich des Kontaktteils 30 der Lotdepots 28 in der in **Fig. 10** dargestellten Testkonfiguration der Chip 21 bei der elektrischen Überprüfung für gut befunden wurde, erfolgt gemäß der in **Fig. 11** dargestellten Übertragungskonfiguration eine Erhöhung der Temperatur, mit der Folge, daß nunmehr auch der höher schmelzende Basisteil 29 der Lotdepots 28 aufschmilzt.

Je nach Ausbildung der Anschlußflächenmetallisierung 26 des Lotdepotträgers 25 kann bei der nachfolgenden Übertragung oder Übergabe der Lotdepots 28 auf die Bumps 22 des Chips 21, die hier durch Haftung der Lotdepots 28 an den benetzten Bumps 22 des Chips 21 und Ablösung der Lotdepots 28 vom Lotdepotträger 25 durch Abheben des Chips 21 bewirkt wird, unter Mitübertragung der Anschlußflächenmetallisierung 26 erfolgen.

Bei dem hier dargestellten Ausführungsbeispiel ist die Anschlußflächenmetallisierung 26 benetzbar und im Lotmaterial des Lotdepots 28 löslich ausgebildet, wohingegen das Material der Leiterbahnstruktur 12 so gewählt ist, daß diese nichtbenetzbar ist und eine Haftung zwischen der Anschlußflächenmetallisierung 26 und der Leiterbahnstruktur 12 nur im festen Zustand möglich ist. Eine derartige Ausbildung der Anschlußflächenmetallisierung 26 bzw. der Leiterbahnstruktur 12 hat zur Folge, daß, wie in **Fig. 12** dargestellt, die Anschlußflächenmetallisierung 26 beim Abheben des Chips 21 mitübertragen wird, so daß eine rückstandsfreie Gesamtübertragung der Lotdepots 28 garantiert ist.

Im Fall einer nichtbenetzbar ausgebildeten Anschlußflächenmetallisierung 26 ist ebenfalls eine rückstandsfreie Übertragung der Lotdepots 28 vom Lotdepotträger 25 auf die Bumps 22 des Chips 21 gewährleistet, da in diesem Fall zwischen den Lotdepots 28 und der Anschlußflächenmetallisierung 26 nur im festen Zustand der Lotdepots Haftkräfte ausgebildet sind, die einer Übertragung der Lotdepots entgegenwirken.

In jedem Fall kann es sich als vorteilhaft erweisen, wenn das Aufschmelzen der Lotdepots 28 in einer inerten oder reduzierenden Atmosphäre erfolgt.

## Patentansprüche

1. Verfahren zum Testen von mit einer Leiterbahnstruktur versehenen Substraten, insbesondere Chips, wobei mittels eines Lotdepotträgers (10, 25), der auf einer Oberseite mit Anschlussflächen (17) zur Anordnung von Lotdepots (19, 28) und deren Übertragung auf entsprechend angeordnete Anschlussflächen (22) eines Substrats (21) und auf seiner Rückseite mit Prüfkontakten (20) versehen ist, während der Übertragung der Lotdepots im schmelzflüssigen Zustand eine elektrische Überprüfung der Leiterbahnstruktur des Substrats erfolgt,
**dadurch gekennzeichnet,**
**dass** die Überprüfung mittels einer mit den Anschlussflächen (17) verbundenen, auf der Oberseite des Lotdepotträgers (10, 25) aufgebrachten Leiterbahnstruktur (12) erfolgt.

2. Verfahren nach Anspruch 1,
**dadurch gekennzeichnet,**
**dass** vor Anordnung der Lotdepots (19) eine Übertragungsmaske (14) mit die Anschlussflächen (17) freigebenden Maskenöffnungen (15) auf die Leiterbahnstruktur (12) aufgebracht wird.

3. Verfahren nach Anspruch 1 oder 2,
**dadurch gekennzeichnet,**
**dass** nach Herstellung eines Berührungskontaktes zwischen den Lotdepots (19, 28) des Lotdepotträgers (10, 25) und den Anschlussflächen (22) des Substrats (21) ein zumindest partielles Aufschmelzen der Lotdepots (19, 28) zur Herstellung einer Lotverbindung zwischen dem Lotdepotträger (10, 25) und dem Substrat (21) erfolgt.

4. Verfahren nach Anspruch 3,
**dadurch gekennzeichnet,**
**dass** bei einem partiellen Aufschmelzen der Lotdepots (28) zunächst ein Aufschmelzen eines benachbart der Anschlussfläche (22) des Substrats (21) angeordneten Kontaktteils (30) und anschließend ein Aufschmelzen eines an den Kontaktteil (30) angrenzenden Basisteils (29) erfolgt.

5. Verfahren nach Anspruch 4,
**dadurch gekennzeichnet,**
**dass** sich während der elektrischen Überprüfung der Leiterbahnstruktur des Substrats (21) der Kontaktteil (30) im schmelzflüssigen Zustand und der Basisteil (29) im festen Zustand befindet.

6. Verfahren nach einem oder mehreren der vorangehenden Ansprüche,
**dadurch gekennzeichnet,**
**dass** bei Übertragung des insgesamt schmelzflüssigen Lotdepots (28) eine Mitübertragung einer auf den Anschlussflächen (17) der Leiterbahnstruktur (12) des Lotdepotträgers (25) angeordneten Anschlussflächenmetallisierung (26) erfolgt.

7. Verfahren nach Anspruch 3,
**dadurch gekennzeichnet,**
**dass** die zum Aufschmelzen der Lotdepots (19, 28) benötigte Energie zumindest anteilig über die Leiterbahnstruktur (12) des Lotdepotträgers (10, 25) in die Lotdepots (19, 28) eingebracht wird.

8. Verfahren nach einem oder mehreren der vorangehenden Ansprüche,
**dadurch gekennzeichnet,**
**dass** während des Bestehens der Verbindung zwischen dem Lotdepotträger (10, 25) und dem Substrat (21) über die Leiterbahnstruktur (12) des Lotdepotträgers (10, 25) eine Temperierung des Substrats (21) erfolgt.

9. Verfahren nach einem oder mehreren der vorangehenden Ansprüche,
**dadurch gekennzeichnet,**
**dass** zur Übertragung der Lotdepots (19, 28) vom Lotdepotträger (10, 25) auf die Anschlussflächen (22) des Substrats (21) das Substrat (21) mit seinen Anschlussflächen (22) in einer Überdeckungslage mit den Lotdepots (19, 28) von oben auf den Lotdepotträger (10, 25) abgesenkt und nachfolgend zusammen mit den an den Anschlussflächen (22) des Substrats (21) haftenden Lotdepots (19, 28) nach oben abgehoben wird.

10. Verfahren nach einem oder mehreren der vorangehenden Ansprüche,
**dadurch gekennzeichnet,**
**dass** das zumindest partielle Aufschmelzen der Lotdepots und/oder deren Übertragung vom Lotdepotträger auf das Substrat in einem gasförmigen oder flüssigen reduzierenden oder inerten Medium erfolgt.

11. Lotdepotträger (10) zur Übertragung von Lotdepots (19, 28) auf Anschlussflächen (22) eines mit einer Leiterbahnstruktur versehenen Substrats (21), aufweisend eine Trägerschicht (11) mit auf einer Oberseite angeordneten Anschlussflächen (17) zur Anordnung von Lotdepots (19, 28) und deren Übertragung auf entsprechend angeordnete Anschlussflächen (22) des Substrats (21), und mit Prüfkontakten (20), die sich auf der Rückseite des Lotdepotträgers (10) befinden,
**dadurch gekennzeichnet,**
**dass** zur Verbindung zwischen den Anschlussflächen (17) und den Prüfkontakten (20) auf der Oberseite der Trägerschicht (11) eine Leiterbahnstruktur (12) ausgebildet ist.

12. Lotdepotträger nach Anspruch 11,
**dadurch gekennzeichnet,**
**dass** die Anschlussflächen (17) zur Anordnung der Lotdepots (19, 28) durch Maskenöffnungen (15) einer auf der Leiterbahnstruktur (12) angeordneten Übertragungsmaske (14) definiert sind.

13. Lotdepotträger nach Anspruch 11,
**dadurch gekennzeichnet,**
**dass** die Anschlussflächen (17) des Lotdepotträgers (10) eine kleinere Benetzungsfläche (24) als die Anschlussflächen (25) des Substrats (21) aufweisen.

14. Lotdepotträger nach einem der Ansprüche 11 bis 13,
**dadurch gekennzeichnet,**
**dass** die Anschlussflächen (17) des Lotdepotträgers (10, 25) mit einer benetzungshemmenden oder benetzungsunfähigen Anschlussflächenmetallisierung (26) versehen sind.

15. Lotdepotträger nach Anspruch 14,
**dadurch gekennzeichnet,**
**dass** die Anschlussflächenmetallisierung (26) eine Wolfram/Titan-Legierung oder eine Wolfram/Titanoxid-Legierung aufweist.

16. Lotdepotträger nach Anspruch 14,
**dadurch gekennzeichnet,**
**dass** die Anschlussflächenmetallisierung (26) aus Wolfram, Titan, Chrom, Tantal oder Molybdän oder deren Oxiden besteht.

17. Lotdepotträger nach einem der Ansprüche 11 bis 13,
**dadurch gekennzeichnet,**
**dass** die Anschlussflächen (17) des Lotdepotträgers (25) mit einer benetzbaren Anschlussflächenmetallisierung (26) auf einer vorzugsweise nichtbenetzbaren Leiterbahnstruktur (12) versehen sind.

18. Lotdepotträger nach Anspruch 17,
**dadurch gekennzeichnet,**
**dass** die Anschlussflächenmetallisierung (26) eine Gold-Legierung oder eine Palladium-Legierung aufweist.

## Claims

1. Method for the testing of substrates which are provided with a strip-conductor structure, in particular chips, wherein by means of a solder-deposit carrier (10, 25), which on an upper side is provided with bond pads (17) for the arranging of solder deposits (19, 28) and their transfer to correspondingly arranged bond pads (22) of a substrate (21), and on its back side is provided with test contacts (20), an electrical check of the strip-conductor structure of the substrate takes place during the transfer to the solder deposits in the molten state,
**characterized in that**
the check takes place by means of a strip-conductor structure (12) connected to the bond pads (17) and applied to the upper side of the solder-deposit carrier (10, 25).

2. Method in accordance with claim 1,
**characterized in that**
before the arranging of the solder deposits (19), a transfer mask (14) with mask openings (15) which free the bond pads (17) is applied to the strip-conductor structure (12).

3. Method in accordance with claim 1 or 2,
**characterized in that**
after production of a physical contact between the solder deposits (19, 28) of the solder-deposit carrier (10, 25) and the bond pads (22) of the substrate (21), an at least partial fusing of the solder deposits (19, 28) takes place in order to produce a solder connection between the solder-deposit carrier (10, 25) and the substrate (21).

4. Method in accordance with claim 3,
**characterized in that**
in the case of a partial fusing of the solder deposits (28), first the fusing of a contact part (30) placed adjacent to the bond pad (22) of the substrate (21) takes place, and then the fusing of a base part (29) that is contiguous with the contact part (30) takes place.

5. Method in accordance with claim 4,
**characterized in that**
during the electrical checking of the strip-conductor structure of the substrate (21), the contact part (30) is in the molten state and the base part (29) is in the solid state.

6. Method in accordance with one or more of the preceding claims,
**characterized in that**
with the transfer of the completely molten solder deposit (28), a co-transfer of a bond-pad metallization (26) that is placed on the bond pads (17) of the strip-conductor structure (12) of the solder-deposit carrier (25) takes place.

7. Method in accordance with claim 3,
**characterized in that**
the energy needed for the fusing of the solder deposits (19, 28) is brought into the solder deposits (19, 28) at least partly by means of the strip-conductor structure (12) of the solder-deposit carrier (10, 25).

8. Method in accordance with one or more of the preceding claims,
**characterized in that**
during the existence of the connection between the solder-deposit carrier (10, 25) and the substrate (21) by means of the strip-conductor structure (12) of the solder-deposit carrier (10, 25), a tempering of the substrate (21) takes place.

9. Method in accordance with one or more of the preceding claims,
**characterized in that**
for the transfer of the solder-deposits (19, 28) from the solder-deposit carrier (10, 25) to the bond pads (22) of the substrate (21), the substrate (21) is lowered, with its bond pads (22) in an overlap position with the solder deposits (19, 28), onto the solder-deposit carrier (10, 25) from above, and is subsequently lifted up together with the solder deposits (19, 28) which are adhering to the bond pads (22) of the substrate (21).

10. Method in accordance with one or more of the preceding claims,
**characterized in that**
the at least partial fusing of the solder deposits and/or their transfer from the solder-deposit carrier to the substrate takes place in a gaseous or liquid reducing or inert medium.

11. Solder-deposit carrier (10) for the transfer of solder deposits (19, 28) to bond pads (22) of a substrate (21) which is provided with a strip-conductor structure, exhibiting a carrier layer (11) with bond pads (17) arranged on an upper side for the arranging of solder deposits (19, 28) and their transfer to correspondingly arranged bond pads (22) of the substrate (21), and with test contacts (20) located on the back side of the solder-deposit carrier (10),
**characterized in that**
for the connection between the bond pads (17) and test contacts (20) on the upper side of the carrier layer (11) a strip-conductor structure (12) is formed.

12. Solder-deposit carrier in accordance with claim 11,
**characterized in that**
the bond pads (17) for the arranging of the solder deposits (19, 28) are defined by means of mask openings (15) in a transfer mask (14) which is placed on the strip-conductor structure (12).

13. Solder-deposit carrier in accordance with claim 11,
**characterized in that**
the bond pads (17) of the solder-deposit carrier (10) exhibit a smaller wetting area (24) than the bond pads (25) of the substrate (21).

14. Solder deposit carrier in accordance with one of the claims 11 to 13,
**characterized in that**
the bond pads (17) of the solder-deposit carrier (10, 25) are provided with a bond-pad metallization (26) which inhibits wetting or is incapable of being wetted.

15. Solder-deposit carrier in accordance with claim 14,
**characterized in that**
the bond-pad metallization (26) exhibits a tungsten/titanium alloy or a tungsten/titanium oxide alloy.

16. Solder-deposit carrier in accordance with claim 14,
**characterized in that**
the bond-pad metallization (26) consists of tungsten, titanium, chrome, tantalum or molybdenum, or their oxides.

17. Solder-deposit carrier in accordance with one of claims 11 to 13,
**characterized in that**
the bond pads (17) of the solder-deposit carrier (25) are provided with a wettable bond-pad metallization (26) on a strip-conductor structure (12) which is preferably not wettable.

18. Solder-deposit carrier in accordance with claim 17,
**characterized in that**
the bond-pad metallization (26) exhibits a gold alloy or a palladium alloy.

## Revendications

1. Procédé pour tester des substrats, en particulier des puces, dotés d'une structure de piste conductrice, un contrôle électrique de la structure de piste conductrice du substrat s'effectuant, pendant le transfert des dépôts de brasure dans l'état en fusion, au moyen d'un support de dépôt de brasure (10, 25), qui est doté sur un côté supérieur de surfaces de raccordement (17) pour l'agencement de dépôts de brasure (19, 28) et leur transfert à des surfaces de raccordement (22) d'un substrat (21) disposées de façon appropriée et qui est pourvu sur sa face arrière de contacts d'essai (20),
**caractérisé en ce que**
le contrôle s'effectue au moyen d'une structure de piste conductrice (12) reliée aux surfaces de raccordement (17) et appliquée sur le côté supérieur du support de dépôt de brasure (10, 25).

2. Procédé selon la revendication 1,
**caractérisé en ce que**,
avant l'agencement des dépôts de brasure (19), un masque de transfert (14) avec des ouvertures de masque (15) libérant les surfaces de raccordement (17) est appliqué sur la structure de piste conductrice (12).

3. Procédé selon la revendication 1 ou 2,
**caractérisé en ce que**
une fusion au moins partielle des dépôts de brasure (19, 28) pour la fabrication d'un assemblage brasé entre le support de dépôt de brasure (10, 25) et le substrat (21) intervient après la fabrication d'un contact de toucher entre les dépôts de brasure (19, 28) du support de dépôt de brasure (10, 25) et les surfaces de raccordement (22) du substrat (21).

4. Procédé selon la revendication 3,
**caractérisé en ce que**,
lors d'une fusion partielle des dépôts de brasure (28), on a d'abord une fusion d'une partie de contact (30) disposée à proximité de la surface de raccordement (22) du substrat (21) et ensuite une fusion d'une partie de base (29) contiguë à la partie de contact (30).

5. Procédé selon la revendication 4,
**caractérisé en ce que**
pendant le contrôle électrique de la structure de piste conductrice du substrat (21), la partie de contact (30) se trouve dans l'état en fusion et la partie de base (29) dans l'état solide.

6. Procédé selon l'une quelconque ou plusieurs des revendications précédentes,
**caractérisé en ce que**,
lors du transfert du dépôt de brasure (28) globalement en fusion, on a un transfert commun d'une métallisation de surface de raccordement (26) disposée sur les surfaces de raccordement (17) de la structure de piste conductrice (12) du support de dépôt de brasure (25).

7. Procédé selon revendication 3,
**caractérisé en ce que**
l'énergie utilisée pour la fusion des dépôts de brasure (19, 28) est introduite dans les dépôts de brasure (19, 28) au moins au pro rata au moyen de la structure de piste conductrice (12) du support de dépôt de brasure (10, 25).

8. Procédé selon l'une quelconque des revendications précédentes,
**caractérisé en ce que**,
pendant l'existence de la liaison entre le support de dépôt de brasure (10, 25) et le substrat (21), on a une mise à température du substrat (21) par la structure de piste conductrice (12) du support de dépôt de brasure (10, 25).

9. Procédé selon l'une quelconque ou plusieurs des revendications précédentes,
**caractérisé en ce que**,
pour le transfert du dépôt de brasure (19, 28) du support de dépôt de brasure (10, 25) aux surfaces de raccordement (22) du substrat (21), le substrat (21) est abaissé avec ses surfaces de raccordement (22) dans une position de recouvrement avec les dépôts de brasure (19, 28) du haut sur le support de dépôt de brasure (10, 25) et est relevé ensuite vers le haut avec les dépôts de brasure (19, 28) s'accrochant aux surfaces de raccordement (22) du substrat (21).

10. Procédé selon l'une quelconque ou plusieurs des revendications précédentes,
**caractérisé en ce que**
la fusion au moins partielle des dépôts de brasure et/ou leur transfert du support de brasure au substrat s'effectue dans un milieu gazeux ou liquide, réducteur ou inerte.

11. Support de dépôt de brasure (10) pour le transfert de dépôts de brasure (19, 28) à des surfaces de raccordement (22) d'un substrat (21) doté d'une structure de piste conductrice, présentant une couche support (11) avec des surfaces de raccordement (17) disposées sur un côté supérieur pour l'agencement de dépôts de brasure (19, 28) et leur transfert à des surfaces de raccordement (22) du substrat (21) disposées de façon appropriée et avec des contacts d'essai (20) qui se trouvent sur le côté arrière du support de dépôt de brasure (10),
**caractérisé en ce que**
une structure de piste conductrice (12) est réalisée sur le côté supérieur de la couche support (11) pour la liaison entre les surfaces de raccordement (17) et les contacts d'essai (20).

12. Support de dépôt de brasure selon la revendication 11,
**caractérisé en ce que**
les surfaces de raccordement (17) pour l'agencement des dépôts de brasure (19, 28) sont définies par des ouvertures de masque (15) d'un masque de transfert (14) disposé sur la structure de piste conductrice (12).

13. Support de dépôt de brasure selon la revendication 11,
**caractérisé en ce que**
les surfaces de raccordement (17) du support de dépôt de brasure (10) présentent une surface d'humectation (24) inférieure aux surfaces de raccordement (25) du substrat (21).

14. Support de dépôt de brasure selon l'une quelconque des revendications 11 à 13,
**caractérisé en ce que**
les surfaces de raccordement (17) du support de dépôt de brasure (10, 25) sont dotées d'une métallisation de surface de raccordement (26) inhibant l'humectation ou non susceptible d'humectation.

15. Support de dépôt de brasure selon la revendication 14,
**caractérisé en ce que**
la métallisation des surfaces de raccordement (26) présente un alliage de tungstène/titane ou un alliage de tungstène/oxyde de titane.

16. Support de dépôt de brasure selon la revendication 14,
**caractérisé en ce que**
la métallisation des surface de raccordement (26) est à base de tungstène, de titane, de chrome, de tantale ou de molybdène ou de leurs oxydes.

17. Support de dépôt de brasure selon l'une quelconque des revendications 11 à 13,
**caractérisé en ce que**
les surfaces de raccordement (17) du support de dépôt de brasure (25) sont dotées d'une métallisation de surface de raccordement (26) humectable sur une surface de piste conductrice (12) de préférence non humectable.

18. Support de dépôt de brasure selon la revendication 17,
**caractérisé en ce que**
la métallisation de surface de raccordement (26) présente un alliage d'or ou un alliage de palladium.
